(19) **Europäisches Patentamt / European Patent Office / Office européen des brevets**

(11) **EP 4 732 972 A1**

(12) **EUROPEAN PATENT APPLICATION**
published in accordance with Art. 153(4) EPC

(43) Date of publication:
29.04.2026 Bulletin 2026/18

(21) Application number: 24825990.5

(22) Date of filing: 20.06.2024

(51) International Patent Classification (IPC):
**B23B 27/14** $^{(2006.01)}$   **B23C 5/16** $^{(2006.01)}$
**C23C 14/06** $^{(2006.01)}$

(52) Cooperative Patent Classification (CPC):
**B23B 27/14; B23C 5/16; C23C 14/06**

(86) International application number:
**PCT/JP2024/022462**

(87) International publication number:
**WO 2024/262589 (26.12.2024 Gazette 2024/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 23.06.2023 JP 2023103045

(71) Applicant: MOLDINO Tool Engineering, Ltd.
Tokyo 130-0026 (JP)

(72) Inventors:
• FUWA, Ryoutarou
Yasu-shi, Shiga 520-2323 (JP)
• SASAKI, Tomoya
Narita-shi, Chiba 286-0825 (JP)

(74) Representative: Hoffmann Eitle
Patent- und Rechtsanwälte PartmbB
Arabellastraße 30
81925 München (DE)

(54) **COATED CUTTING TOOL**

(57) A coated cutting tool including a substrate, and a hard coating film on the substrate. The hard coating film consists of a nitride or a carbonitride containing aluminum (Al) at 50 atom% or more and 70 atom% or less, chromium (Cr) at 20 atom% or more and 50 atom% or less, and silicon (Si) at 4 atom% or more and 15 atom% or less, with respect to a total amount of metals including a metalloid. In the hard coating film, an atomic ratio (atom%) A of a metal element including a metalloid and an atomic ratio (atom%) B of nitrogen satisfy a relationship of $1.07 < B/A < 1.30$. In the hard coating film, in an intensity profile obtained from an X-ray diffraction pattern or a selected-area diffraction pattern of a transmission electron microscope, a peak intensity caused by a (200) plane or a (111) plane of a cubic crystal shows a maximum intensity, and in the intensity profile obtained from the selected-area diffraction pattern, no peak primarily attributed to a hexagonal crystal is present.

EP 4 732 972 A1

**Description**

TECHNICAL FIELD

The present invention relates to a coated cutting tool.
Priority is claimed on Japanese Patent Application No. 2023-103045, filed June 23, 2023, the content of which is incorporated herein by reference.

BACKGROUND ART

An AlCrSi nitride is a type of film excellent in heat resistance and wear resistance, and is applied to coated cutting tools. The present applicant proposes to further increase a content ratio of nitrogen in a hard coating film of an AlCrSi nitride having a large content of Si and a fine structure (Patent Document 1). The hard coating film described in Patent Document 1 has excellent wear resistance, and can improve the durability of a coated cutting tool in milling of high-hardness steel. Patent Document 1 shows that, in a case where a nitrogen content ratio of the hard coating film is too large, a residual compressive stress of the hard coating film is excessively increased, and the hard coating film is likely to undergo self-fracture, and the durability of the tool is decreased. Therefore, in Patent Document 1, an upper limit value of B/A, which is a ratio of an atomic ratio B of nitrogen to an atomic ratio A of a metal element, is set to 1.07.

Citation List

Patent Document

Patent Document 1: PCT International Publication No. WO2015/141743

SUMMARY OF INVENTION

Technical Problem

According to the studies of the present inventor, it has been found that, depending on the type of a film deposition apparatus, it is difficult to control nitrogen contained in the hard coating film, and the nitrogen may be further increased than the upper limit value of B/A defined in Patent Document 1. In a case where a coated cutting tool excellent in durability is obtained in a range where the content ratio of nitrogen is higher than that in Patent Document 1, the application range is expanded and productivity is also improved. An object of the present invention is to provide a coated cutting tool excellent in durability even in a case where a content ratio of nitrogen is high, for an AlCrSi nitride having a large content of Si and a refined structure.

Solution to Problem

(1) An aspect of the present invention is a coated cutting tool including a substrate, and a hard coating film over the substrate, in which the hard coating film consists of a nitride or a carbonitride containing aluminum (Al) at 50 atom% or more and 70 atom% or less, chromium (Cr) at 20 atom% or more and 50 atom% or less, and silicon (Si) at 4 atom% or more and 15 atom% or less, with respect to a total amount of metals including a metalloid, and in the hard coating film, in a case where a total of metal elements including a metalloid, and non-metal elements is set to 100 atom%, an atomic ratio (atom%) A of the metal elements including the metalloid and an atomic ratio (atom%) B of nitrogen satisfy a relationship of $1.07 < B/A < 1.30$, and in an intensity profile obtained from an X-ray diffraction pattern or a selected-area diffraction pattern of a transmission electron microscope, a peak intensity caused by a (200) plane or a (111) plane of a cubic crystal shows a maximum intensity, and in the intensity profile obtained from the selected-area diffraction pattern, no peak primarily attributed to a hexagonal crystal is present.
(2) In (1), it is preferable that $1.1 < B/A < 1.25$.
(3) In (1) or (2), it is preferable that in observation of a surface or a cross section of the hard coating film, the number of droplets having an equivalent circular diameter of 3 $\mu$m or more is 5 or less in a range of 50 $\mu$m $\times$ 40 $\mu$m.
(4) In any one of (1) to (3), it is preferable that a compressive residual stress of the hard coating film is 1.0 GPa or more and 4.0 GPa or less.
(5) In any one of (1) to (4), the coated cutting tool may include an interlayer coat provided between the hard coating film and the substrate.

(6) In any one of (1) to (5), the coated cutting tool may include an upper layer provided over the hard coating film.

(7) In (6), it is preferable that the upper layer is a nitride or a carbonitride.

(8) In (7), it is preferable that the upper layer is the nitride or the carbonitride containing titanium (Ti) at 60 atom% or more and 95 atom% or less and silicon (Si) at 5 atom% or more and 40 atom% or less with respect to the total amount of the metals including the metalloid.

Advantageous Effects of Invention

According to the present invention, it is possible to provide a coated cutting tool having excellent durability.

BRIEF DESCRIPTION OF DRAWINGS

FIG. 1 is a diagram showing a selected-area diffraction pattern of a hard coating film according to the present example.

FIG. 2 is a diagram showing an intensity profile obtained from the selected-area diffraction pattern of FIG. 1.

FIG. 3 is an example of a surface observation photograph ($\times$2,000 times) of a hard coating film according to the present example.

FIG. 4 is an example of a surface observation photograph ($\times$2,000 times) of a hard coating film according to a conventional example.

DESCRIPTION OF EMBODIMENTS

The present inventors have found that, in an AlCrSi nitride having a large content of Si, even in a case where a content ratio of nitrogen is high, the excellent durability is exhibited by further reducing the hexagonal AlN contained at a micro level, and have reached the present invention. Hereinafter, details of the present embodiment will be described.

Hereinafter, the details of the embodiment of the present invention will be described.

The coated cutting tool of the present embodiment is a coated cutting tool having a hard coating film consisting of a nitride or a carbonitride of AlCrSi on a surface of the tool.

Details of the component composition, structure, characteristics, manufacturing method, and the like of the hard coating film constituting the coated cutting tool of the present embodiment will be described.

<Component composition: Aluminum (Al), Chromium (Cr), Silicon (Si)>

The hard coating film according to the present embodiment consists of a nitride or a carbonitride containing aluminum (Al) at 50 atom% or more and 70 atom% or less, chromium (Cr) at 20 atom% or more and 50 atom% or less, and silicon (Si) at 4 atom% or more and 15 atom% or less, with respect to a total amount of metal elements including a metalloid (hereinafter, referred to as metal elements).

The nitride or the carbonitride of AlCrSi is a type of film excellent in wear resistance and heat resistance. Al is an element that imparts heat resistance to the hard coating film. The hard coating film increases in heat resistance by containing a certain amount of Al. In addition, an oxidation protective film is easily formed on the tool surface, and tool damage is easily suppressed. Furthermore, as the coat structure becomes refined, wear of the hard coating film due to adhesion is easily suppressed. In addition, a cutting resistance tends to decrease. To sufficiently exhibit the addition effect of these Al, the hard coating film according to the present embodiment has Al at 50 atom% or more. Furthermore, it is preferable that Al is 55 atom% or more. On the other hand, in a case where Al becomes excessive, the hexagonal AlN is increased, and the hard coating film becomes brittle. Therefore, the hard coating film according to the present embodiment has Al at 70 atom% or less. Furthermore, it is preferable that Al is 68 atom% or less.

Cr is an element that imparts wear resistance to the hard coating film. The hard coating film increases in wear resistance by containing a certain amount of Cr. The hard coating film according to the present embodiment has Cr at 30 atom% or more. Furthermore, it is preferable that Cr is 35 atom% or more. On the other hand, in a case where Cr becomes excessive, the heat resistance of the hard coating film is decreased. Therefore, the hard coating film according to the present embodiment has Cr at 50 atom% or less. Furthermore, it is preferable that Cr is 45 atom% or less.

It is preferable that the hard coating film according to the present embodiment has a total of Al and Cr at 85 atom% or more. Furthermore, it is preferable that the total of Al and Cr is 90 atom% or more.

Si is an element that refines the structure of the hard coating film. The wear resistance and the heat resistance are improved by refining the coat structure. The hard coating film according to the present embodiment has Si at 4 atom% or more. Furthermore, it is preferable that Si is 5 atom% or more. On the other hand, in a case where the content ratio of Si becomes excessive, the hexagonal AlN is increased, and the durability of the coated cutting tool is decreased. Therefore, the hard coating film according to the present embodiment has Si at 15 atom% or less. Furthermore, it is preferable that Si is 12 atom% or less.

The metal element content ratio of the hard coating film according to the present embodiment can be measured for the mirror-finished hard coating film using an electron probe microanalyzer (EPMA). In this case, for example, after the surface of the hard coating film is mirror-finished, the analysis range of about 1 µm in diameter can be analyzed at five points, and can be obtained from the average of three points excluding the maximum value and the minimum value.

<Atomic ratio A of metal element and atomic ratio B of nitrogen>

In the hard coating film according to the present embodiment, in a case where a total of the metal elements including the metalloid, and a non-metal element is set to 100 atom%, an atomic ratio A of the metal element including the metalloid and an atomic ratio B of nitrogen satisfy a relationship of 1.07 < B/A < 1.30. As the values of the atomic ratios A and B, values measured by EPMA by the above-described measurement method are used. The non-metal element may be carbon or oxygen in addition to nitrogen. Ar may be included. In a case where the value of B/A is larger than 1.07, a complete nitride is sufficiently formed at a micro level. On the other hand, in a case where the value of B/A is larger than 1.30, the coat is likely to be destroyed even in a case where the hexagonal AlN is decreased at a micro level. B/A is preferably larger than 1.10, and more preferably larger than 1.15. B/A is preferably less than 1.25, and more preferably less than 1.23. B/A is preferably 1.10 < B/A < 1.25. Furthermore, the B/A is preferably more than 1.15 and less than 1.23.

<Crystal structure>

In the hard coating film according to the present embodiment, in an intensity profile obtained from an X-ray diffraction pattern or a selected-area diffraction pattern of a transmission electron microscope, a peak intensity ascribable to a (200) plane or a (111) plane of a cubic crystal shows the maximum intensity. In the intensity profile obtained from the selected-area diffraction pattern, no peak primarily attributed to a hexagonal crystal is present. As a result, it is estimated that the brittle hexagonal AlN contained in the hard coating film is reduced to an extremely small level, and even in a case where the nitrogen contained in the hard coating film increases such that B/A exceeds 1.07, the coated cutting tool becomes one having excellent durability.

The intensity profile obtained from the selected-area diffraction pattern is an intensity profile in which the horizontal axis represents the distance (radius r) from the center of the (000) plane spot, and the vertical axis represents the integrated intensity (arbitrary units) along the circumference of a circle at each radius r. In the intensity profile obtained from the selected-area diffraction pattern, a peak primarily attributed to a hexagonal crystal appears in a range of a distance of 3 to 4 nm from the center of the (000) spot. In the present embodiment, the expression "no peak primarily attributed to a hexagonal crystal is present" means that no peak whose intensity is larger than that of adjacent regions is present within a distance range of 3 to 4 nm from the spot center.

In the evaluation of the intensity profile obtained from the selected-area diffraction pattern in the present embodiment, the background is removed and the evaluation is performed. Even in a case where a diffraction pattern of the hexagonal AlN is confirmed in the selected-area diffraction pattern, with the amount being minute, no peak (apex) appears in the intensity profile, and the profile shows only a slight swelling.

The hard coating film according to the present embodiment may contain metal elements other than Al, Cr, and Si within a range satisfying the above-described requirements. For example, one or two or more elements selected from elements of Group IVa, Group Va, and Group VIa of the periodic table, B, Y, Cu for the purpose of improving the wear resistance, heat resistance, lubricity, or the like of the hard coating film. To improve the properties of the hard coating film, these elements are elements that are generally added to AlTiN-based or AlCrN-based hard coating films and do not remarkably degrade the durability of the coated cutting tool as long as the content percentage thereof does not become excessive. In a case where the hard coating film according to the present embodiment contains the metal elements other than Al, Cr, and Si, a total content ratio thereof is preferably 10 atom% or less. Furthermore, it is preferably 5 atom% or less.

In the observation of the surface or the cross section of the hard coating film according to the present embodiment, the number of droplets having an equivalent circular diameter of 3 µm or more is 5 or less in a range of 50 µm × 40 µm. Furthermore, it is preferably 2 or less. In an arc ion plating method, droplets according to the invention are deposits on the hard coating film caused by molten particles of approximately 1 to several tens of µm flying out from a cathode. The durability of the tool is improved by reducing the coarse droplets contained in the hard coating film. Furthermore, in the observation of the surface or the cross section of the hard coating film according to the present embodiment, it is preferable that the number of droplets having an equivalent circular diameter of 5 µm or more is 1 or less in a range of 50 µm × 40 µm. The durability of the tool is improved by reducing the more coarse droplets.

The droplets of the hard coating film may be observed at a magnification of 2,000 with an electron microscope, and the average may be determined by observing five or more fields of view each having an area of 50 µm × 40 µm.

The hard coating film according to the present embodiment preferably has a residual compressive stress of 1.0 GPa or more and 4.0 GPa or less. It is preferable that the residual compressive stress is 1.0 GPa or more and 4.0 GPa or less, thereby suppressing peeling of the coating.

The coated cutting tool according to the present embodiment may be provided with an interlayer coat between the substrate and the hard coating film, as necessary. For example, a nitride, a carbonitride, or a carbide containing one or more elements selected from titanium (Ti), aluminum (Al), and chromium (Cr) may be provided. In addition, a modified layer by metal bombardment may be provided. Furthermore, an upper layer may be provided over the hard coating film to improve the durability of the coated cutting tool. The upper layer is preferably a nitride or a carbonitride. The upper layer is preferably a nitride or a carbonitride containing titanium (Ti) at 60 atom% or more and 95 atom% or less and silicon (Si) at 5 atom% or more and 40 atom% or less.

The hard coating film according to the present embodiment is a physical vapor deposition film. The hard coating film according to the present embodiment is preferably a hard coating film coated by an arc ion plating method, which is a physical vapor deposition film having excellent adhesiveness. The hard coating film containing a large amount of Al is likely to generate a large number of droplets. Although the hard coating film containing a large amount of Al formed by the arc ion plating method has a tendency to generate coarse droplets, the number of such large droplets is reduced, whereby the coated cutting tool tends to have stable tool performance.

It is preferable that the coated cutting tool according to the present embodiment is coated using a film deposition apparatus including a cathode having permanent magnets disposed on a rear surface and an outer peripheral surface of a target, and further having a magnetic field generating coil disposed in front of the target to generate a magnetic field that pushes plasma forward. In addition, it is preferable that a distance from the target surface to the substrate is 250 mm or more. As the distance from the target surface to the substrate is longer, the coarse droplets reaching the substrate tend to be reduced.

The coating temperature is preferably 450°C to 550°C. The negative bias voltage applied to the substrate is preferably -180 to -120 V. The pressure inside the furnace is preferably 2 to 8 Pa. The input current to the target is preferably 100 to 200 A. The input current to the magnetic field generating coil is preferably 3 to 10 A. Examples

<substrate>

As the substrate, a two-flute ball end mill made of a cemented carbide having a composition of WC (bal.)-Co (8% by mass)-Cr (0.5% by mass)-VC (0.3% by mass), an average WC grain size of 0.6 $\mu$m, and a hardness of 93.9 HRA was prepared. In addition, a test piece made of a cemented carbide was prepared for measuring the residual stress.

<Manufacturing method>

For film formation, a film deposition apparatus of an arc ion plating method was used. The device includes a plurality of cathodes (arc evaporation sources), a vacuum container, and a substrate rotation mechanism.

The apparatus used for coating in the present example includes a cathode in which a permanent magnet is disposed on a rear surface and an outer peripheral surface of a target, and a magnetic field generating coil that generates a magnetic field for pushing plasma forward is provided in front of the target. In addition, the distance from the target surface to the substrate is 400 mm.

The inside of the vacuum container is evacuated by a vacuum pump, and the gas is introduced from a supply port. The substrate installed in the vacuum container is connected to a bias power supply, and a negative bias voltage is independently applied to the substrate.

In the substrate rotation mechanism, a work table, a plate-shaped jig on the work table, and a pipe-shaped jig on the plate-shaped jig are attached, the work table rotates at a speed of 3 rotations per minute, and the plate-shaped jig and the pipe-shaped jig each perform both rotation and revolution.

<Heating and vacuum evacuation step>

The substrate was fixed to the pipe-shaped jig in the vacuum container, and the pre-deposition process was performed as follows. First, the inside of the vacuum container was vacuum-exhausted to $5 \times 10^{-3}$ Pa or lower. Thereafter, the substrate was heated up to a temperature of 500°C with a heater installed in the vacuum container, and the vacuum container was vacuum-exhausted. As a result, the substrate temperature was set to 500°C, and the pressure in the vacuum container was set to $5 \times 10^{-3}$ Pa or less.

<Ar bombardment step>

Thereafter, an argon (Ar) gas was introduced into the vacuum container, and the pressure inside the vacuum container was set to about 0.50 Pa. Subsequently, a current of 20 A was supplied to a filament electrode, a negative bias voltage of -150 V was applied to the substrate, and Ar bombardment was performed for 60 minutes.

<Deposition process>

After the Ar bombardment, the gas in the vacuum container was replaced with nitrogen, and the pressure in the vacuum container was set to 4 Pa. A current of 100 A was supplied to an Al60Cr30Si10 target (the numerical value is an atomic ratio), a current of 5 A was supplied to the magnetic field generating coil, and a bias voltage of - 150 V was applied to the substrate to coat a hard coating film of a nitride having a film thickness of about 2 $\mu$m. Subsequently, a current of 150 A was supplied to a Ti75Si25 target, a current of 5 A was supplied to the magnetic field generating coil, and a bias voltage of -50 V was applied to the substrate to coat an upper layer of a nitride having a film thickness of about 1 $\mu$m.

In the coating of the conventional example, a film deposition apparatus including a cathode in which a permanent magnet was disposed on a rear surface and an outer peripheral surface of a target was used. In addition, the distance from the target surface to the substrate is 170 mm. The deposition conditions were the same as those of the coating of the present example described above, except that there was no current input to the magnetic field generating coil. The hard coating film according to the conventional example corresponds to that of Japanese Patent No. 6410797.

<<Composition analysis>>

The coat composition was measured using wavelength dispersive electron probe microanalysis (WDS-EPMA) attached to an electron probe microanalyzer (JXA-8500F, manufactured by JEOL Ltd.). The ball end mill for physical property evaluation was mirror-finished, and the measurement was performed at an acceleration voltage of 10 kV, an irradiation current of $5 \times 10^{-8}$ A, and an acquisition time of 10 seconds, and the average value of five points in a range of a diameter of about 1 $\mu$m was determined as the composition. The average composition of the hard coating film according to the present example and the conventional example was (Al56Cr33Si11)N. In addition, B/A of the present example was 1.20.

<<TEM analysis>>

The microanalysis was performed with a field emission transmission electron microscope (JEM-2100F, manufactured by JEOL Ltd.). The selected-area diffraction pattern of the hard coating film was determined under conditions of an acceleration voltage of 200 kV, a selected-area region of $\varphi$500 nm, a camera length of 100 cm, and a quantity of incidence electron of 5.0 pA/cm$^2$ (on a fluorescent plate). The center portion of the hard coating film of the AlCrSi nitride in the film thickness growth direction was analyzed. A brightness of the obtained selected-area diffraction pattern was converted to obtain an intensity profile.

<<Residual stress>>

The residual stress and the crystal structure were measured by a $\sin^2\psi$ method using an X-ray diffractometer.

The compressive residual stress of the present example and the comparative example was about 3 GPa.

(Condition) Dry processing

    Tool: two-flute carbide ball end mill
    Model number: EPDBE2010-6, ball radius of 0.5 mm
    Cutting method: Bottom cutting
    Work material: STAVAX (52 HRC) (manufactured by Bohler-Uddeholm Co., Ltd.)
    Depth of cut: 0.04 mm in an axial direction, 0.04 mm in a radial direction
    Cutting speed: 75.4 m/min
    One blade feed amount: 0.0179 mm/blade
    Cutting distance: 15 m
    Evaluation method: After cutting, the work material was observed using a scanning electron microscope at a magnification of 1000 times to measure widths of abrasion between the tool and the work material on a flank face of the tool, and a portion having the largest abrasion width thereamong was defined as a flank face maximum wear width.

[Table 1]

|  | Maximum wear width ($\mu$m) |
| --- | --- |
| Present example | 6 |
| Conventional example | 9 |

In the present example, the maximum wear width was smaller than that in the conventional example.

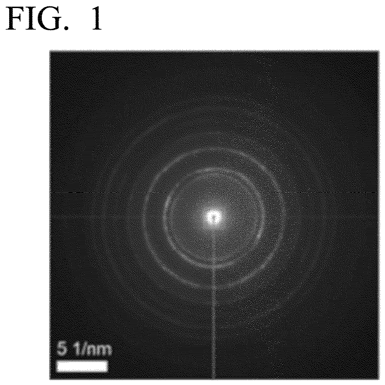

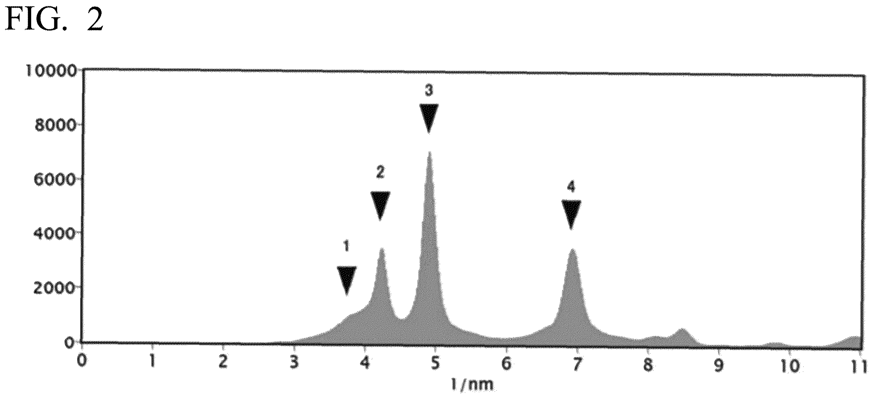

FIG. 1 shows a selected-area diffraction pattern of the hard coating film according to the present example. FIG. 2 shows an intensity profile of the selected-area diffraction pattern obtained from FIG. 1. The peak "2" in FIG. 2 is a peak intensity corresponding to the (111) plane of the cubic crystal, the peak "3" is a peak intensity corresponding to the (200) plane of the cubic crystal, and the peak "4" is a peak intensity corresponding to the (220) plane of the cubic crystal. The peak "1" was slightly swollen, but there was no sharp peak such as the peaks "2" to "4". That is, in the hard coating film according to the present example, no peak primarily attributed to a hexagonal crystal was present. It was confirmed that the present example had a small amount of the hexagonal AlN.

It is estimated that in the present example, the durability was excellent compared to the conventional example even in a case where the content ratio of nitrogen in the hard coating film was high because the hexagonal AlN at the micro level is extremely small.

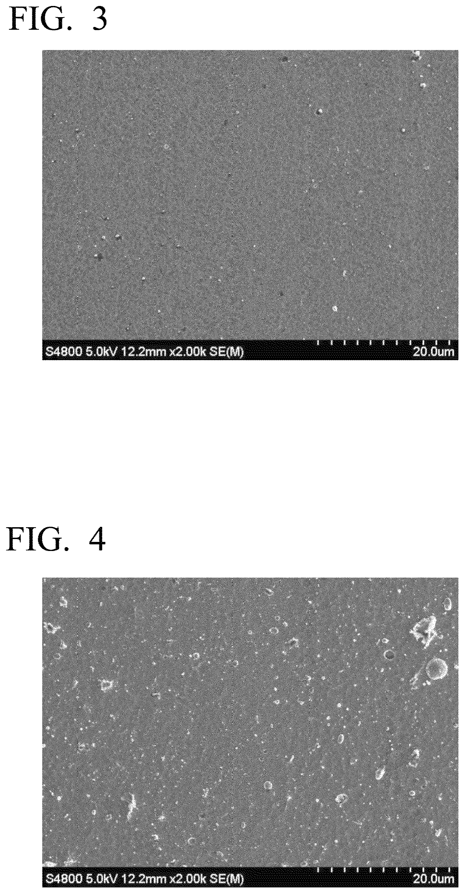

FIG. 3 shows an example of a surface observation photograph of the coated cutting tool according to the present example. FIG. 4 shows an example of a surface observation photograph of the coated cutting tool according to the conventional example. It was confirmed that the present example had fewer coarse droplets than the conventional example. Depending on the tool shape or the processing conditions, droplets significantly affect the tool performance. The coated cutting tool according to the present example is more suitable for a smaller diameter tool. It is expected that the durability is further improved compared to the conventional example by applying the hard coating film according to the present example to a small diameter tool in which the influence by the droplets is large.

## Claims

1. A coated cutting tool comprising:

   a substrate; and
   a hard coating film on the substrate,
   wherein the hard coating film consists of a nitride or a carbonitride containing aluminum (Al) at 50 atom% or more and 70 atom% or less, chromium (Cr) at 20 atom% or more and 50 atom% or less, and silicon (Si) at 4 atom% or more and 15 atom% or less, with respect to a total amount of metals including a metalloid, and in the hard coating film, in a case where a total of metal elements including a metalloid, and non-metal elements is set to 100 atom%, an atomic ratio (atom%) A of the metal elements including the metalloid and an atomic ratio (atom%) B of nitrogen satisfy a relationship of 1.07 < B/A < 1.30, and
   in an intensity profile obtained from an X-ray diffraction pattern or a selected-area diffraction pattern of a transmission electron microscope, a peak intensity caused by a (200) plane or a (111) plane of a cubic crystal shows a maximum intensity, and in the intensity profile obtained from the selected-area diffraction pattern, no peak primarily attributed to a hexagonal crystal is present.

2. The coated cutting tool according to Claim 1,
   wherein

$$1.1 < B/A < 1.25.$$

3. The coated cutting tool according to Claim 1 or 2,
   wherein, in observation of a surface or a cross section of the hard coating film, the number of droplets having an equivalent circular diameter of 3 $\mu$m or more is 5 or less in a range of 50 $\mu$m $\times$ 40 $\mu$m.

4. The coated cutting tool according to Claim 1,
   wherein a compressive residual stress of the hard coating film is 1.0 GPa or more and 5.0 GPa or less.

5. The coated cutting tool according to Claim 1, further comprising:
   an interlayer coat provided between the hard coating film and the substrate.

6. The coated cutting tool according to Claim 1, further comprising
an upper layer provided over the hard coating film.

7. The coated cutting tool according to Claim 6,
wherein the upper layer is a nitride or a carbonitride.

8. The coated cutting tool according to Claim 7,
wherein the upper layer is the nitride or the carbonitride containing titanium (Ti) at 60 atom% or more and 95 atom% or less and silicon (Si) at 5 atom% or more and 40 atom% or less with respect to the total amount of the metals including the metalloid.

FIG. 1

FIG. 2

FIG. 3

FIG. 4

## INTERNATIONAL SEARCH REPORT

| International application No. |
|---|
| **PCT/JP2024/022462** |

**A. CLASSIFICATION OF SUBJECT MATTER**

***B23B 27/14***(2006.01)i; ***B23C 5/16***(2006.01)i; ***C23C 14/06***(2006.01)i
FI:   B23B27/14 A; B23C5/16; C23C14/06 A; C23C14/06 H

According to International Patent Classification (IPC) or to both national classification and IPC

**B. FIELDS SEARCHED**

Minimum documentation searched (classification system followed by classification symbols)

B23B27/14; B23C5/16; B23B51/00; C23C14/06

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-238736 A (HITACHI TOOL ENGINEERING LTD.) 26 August 2004 (2004-08-26) paragraphs [0004]-[0051] | 1-8 |
| A | WO 2020/194899 A1 (MOLDINO TOOL ENGINEERING, LTD.) 01 October 2020 (2020-10-01) paragraph [0019], table 1 | 1-8 |
| A | WO 2022/202729 A1 (MOLDINO TOOL ENGINEERING, LTD.) 29 September 2022 (2022-09-29) table 1 | 1-8 |
| A | WO 2023/008133 A1 (KYOCERA CORPORATION) 02 February 2023 (2023-02-02) | 1-8 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 August 2024** | **13 August 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/022462**

| Patent document cited in search report | | | Publication date (day/month/year) | Patent family member(s) | | | Publication date (day/month/year) |
|---|---|---|---|---|---|---|---|
| JP | 2004-238736 | A | 26 August 2004 | JP | 2008-13852 | A | |
| WO | 2020/194899 | A1 | 01 October 2020 | US | 2022/0040769 | A1 | |
| | | | | paragraphs [0034]-[0035], table 1 | | | |
| | | | | EP | 3943222 | A1 | |
| | | | | CN | 113226604 | A | |
| | | | | KR | 10-2021-0092264 | A | |
| WO | 2022/202729 | A1 | 29 September 2022 | US | 2023/0390829 | A1 | |
| | | | | table 1 | | | |
| | | | | EP | 4316707 | A1 | |
| | | | | CN | 116490638 | A | |
| | | | | KR | 10-2023-0093316 | A | |
| WO | 2023/008133 | A1 | 02 February 2023 | CN | 117529380 | A | |

Form PCT/ISA/210 (patent family annex) (July 2022)

**EP 4 732 972 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023103045 A
- WO 2015141743 A
- JP 6410797 B